# EUROPEAN PATENT SPECIFICATION

(11) **EP 4 425 041 B1**
(45) Date of publication and mention of the grant of the patent: **28.01.2026**
(21) Application number: 22960475.6
(22) Date of filing: 09.10.2022
(51) Int. Cl.: F21V 21/30, F21S 8/00, F21V 31/00, F21W 131/406

(54) **EASY-TO-MAINTAIN WATERPROOF CHASSIS, AND STAGE LAMP HAVING SAME**
LEICHT ZU UNTERHALTENDES WASSERDICHTES CHASSIS UND BÜHNENLAMPE DAMIT
CHÂSSIS ÉTANCHE À L'EAU FACILE D'ENTRETIEN, ET LAMPE DE SCÈNE LE COMPRENANT

(30) Priority: 30.09.2022 CN 202211211824
(43) Date of publication of application: 04.09.2024
(73) Proprietor: Guangzhou Haoyang Electronic Co., Ltd., Guangzhou, Guangdong 511450 (CN)
(72) Inventor: JIANG, Weikai, Guangzhou, Guangdong 511450 (CN)
(74) Representative: Puschmann Borchert Kaiser Klettner Patentanwälte Partnerschaft mbB
(86) International application number: PCT/CN2022/124061
(87) International publication number: WO 2024/065871

(56) References cited:
- EP-A2- 2 503 232
- CN-A- 104 566 035
- CN-A- 112 539 388
- CN-A- 112 539 388
- CN-U- 214 222 845
- CN-U- 214 627 606
- CN-U- 214 627 606
- CN-U- 215 061 578
- CN-U- 215 061 578

## Description

### TECHNICAL FIELD

The present invention relates to the technical field of stage light fixtures, and more particularly, relates to a waterproof base convenient to maintain and a stage light fixture having the same.

### BACKGROUND

Generally, a base of a waterproof stage light fixture is in form of a cylinder body by drawing aluminum processing, with a front plate and a rear plate respectively disposed at two end openings of the cylinder body to form a closed cavity. In such light fixture, a pivoting shaft of a support arm of the light fixture penetrates the side wall of the cylinder body and inserts into the closed cavity. With such configuration, although well waterproof effect can be achieved, maintenance for the interior of the base can only be conducted through the two end openings, which improves difficulties of maintenance, and it is even necessary to completely separate the base with the support arm, causing more complicated to maintain. Prior art waterproof stage light fixtures are known from CN 215061578U, CN 214627606U and CN 112539388U.

### SUMMARY

It is therefore an object of the present invention to provide a waterproof base convenient to maintain which is free from the aforesaid drawbacks of the prior art. The base according to the present invention can conduct maintenance of the interior thereof by removing an upper cover from a bottom frame without separating the base with the other components of the light fixture, such as a support arm.

According to the present invention, the waterproof base convenient to maintain includes a bottom frame and an upper cover with a pivoting hole covering on the bottom frame. The bottom frame is integrally formed by die-casting. The upper cover includes a first cover body and a second cover body which are spliced to each other. The pivoting hole is formed by jointly splicing the first cover body and the second cover body, and an oil seal for sealing an outer side of a pivoting shaft of the light fixture penetrated the pivoting hole is provided at the pivoting hole. The oil seal is mounted and fixed by a mounting plate. A first sealing strip is further provided to seal the first cover body, the second cover body and the mounting plate with respect to each other. The first cover body and the second cover body are respectively abutted against the bottom frame, and a second sealing strip is provided at each abutting position.

In the waterproof base convenient to maintain according to the present invention, the upper cover is divided into the first cover body and the second cover body, and the pivoting hole is formed by jointly splicing the first cover body and the second cover body, so that it is possible to remove the upper cover from the bottom frame without disassembling other components to conduct convenient and quick maintenance on the interior of the waterproof base. In addition, the present invention uses oil seal to seal the outer side of the pivoting shaft of the light fixture, the first cover body, the second cover body and the mounting plate are sealed with respect to each other by the first sealing strip, and the first cover body and the second cover body respectively abut against the bottom frame, with the second sealing strip sealing each abutting position, in such easy way, the whole waterproof base can be waterproof. Compared to the existing waterproof base in form of a cylinder body by drawing aluminum processing, with two end openings closed, the structure of the waterproof base according to the present invention can be more flexible and can achieve more possibility of modeling designs of the base. What's more, the bottom frame is integrally formed by die-casting, resulting in rapid processing and high strength, and splicing assembly is not required, accordingly, the waterproof performance is much better.

According to the invention, the first sealing strip includes two waterproof rubber strips, each being respectively disposed on sides of the first cover body and the second cover body close to each other. The two waterproof rubber strips respectively seal the periphery of the mounting plate close to the first cover body and the second cover body. That is, the waterproof rubber strip may seal a portion where the first cover body or the second cover body and the mounting plate are in contact with each other, and/or seal a portion where the first cover body and the second cover body are in contact with each other, thereby making the entire upper cover waterproof.

According to the present invention, the second sealing strips disposed between the first cover body and the bottom frame as well as between the second cover body and the bottom frame are independent from each other, and each second sealing strip is respectively connected with each waterproof rubber strip into a whole. That is, each second sealing strip and the respect waterproof rubber strip are connected into a rubber ring to seal the periphery of the first cover body or the second cover body, so that there is no splicing gap between the second sealing strip and the waterproof rubber strip, thus achieving better waterproof performance.

According to the present invention, the first sealing strip is located on a side of the mounting plate away from the bottom frame. In such configuration, the first cover body and the second cover body may be horizontally pushed or pressed from top to bottom to assembly together. However, the first cover body and the second cover body are preferably pressed from top to bottom according to one embodiment of the present invention.

A clamping fastener is preferably provided on the first cover body and/or the second cover body, which is supported on a side of the mounting plate close to the bottom frame. The clamping fastener enables the first cover body and/or the second cover body to be fastened to the mounting plate, so as to ensure that the first sealing strip is always in a compressed state, thereby achieving more stable waterproof performance.

According to another embodiment, the first sealing strip is located on a side of the mounting plate close to the first cover body and the second cover body. In this way, the first cover body and the second cover body may be horizontally pushed to assembly the first cover body and the second cover body.

Accordingly, an accommodating groove for accommodating the first sealing strip is formed on a side of the mounting plate close to the first cover body and the second cover body, and an edge of the first cover body and/or the second cover body is at least partially inserted into the accommodating groove. In this way, the first sealing strip is fixed to the mounting plate, and the edge of the first cover body and/or the second cover body is at least partially inserted into the accommodating groove and cooperates with the side wall of the accommodating groove to press against the first sealing strip, so that more stable waterproof performance can be realized.

The first sealing strip at least partially extends out of the accommodating groove to bent to tighten the outer side wall of the accommodating groove. In such a way, the first sealing strip can be fixed more firmly, and the first sealing strip can prevent from being displaced or twisted when the edge of the first cover body and/or the second cover body is inserted into the accommodating groove.

According to the present invention, the second sealing strip is located on a side of the bottom frame close to the mounting plate, or is located on the outer side of the bottom frame, or is partially located on the side of the bottom frame close to the mounting plate, and partially located on the outer side of the bottom frame.

According to the present invention, each of two opposite sides of the mounting plate extends along the cover body to form a connecting plate. Each connecting plate is fixed to the bottom frame, the sides of the first cover body and the second cover body close to each other respectively abut against the mounting plate, and the first sealing strip is disposed between the first cover body and the mounting plate as well as between the second cover body and the mounting plate respectively. In this way, the first cover body and the second cover body are not in direct contact with each other. The connecting plate is located between the first cover body and the second cover body, the first cover body and the second cover body respectively abut against and are sealed to the mounting plate, and the end of the mounting plate is fixed to the bottom frame.

A third sealing strip is disposed at a position where the bottom frame abuts against the connecting plate, and the third sealing strip abuts against the first sealing strip or the second sealing strip into a whole, or connects with the first sealing strip or the second sealing strip into a whole. In such a way, the third sealing strip not only seals the mounting plate and the bottom frame, and the third sealing strip is also in sealed connection with the first sealing strip or the second sealing strip, thereby realizing the waterproof function of the waterproof base.

According to the present invention, a fixing plate for fixing the oil seal to the mounting plate is further provided. The fixing plate has two connecting plates respectively extending from two opposite sides perpendicular to the cover body, which are fixed to the bottom frame. The fixing plate can support the upper cover to improve the strength of the waterproof base, especially when the waterproof base is made of a plastic material.

According to the present invention, the mounting plate is fixed to a bottom plate of the bottom frame via a connecting column.

According to the present invention, the bottom frame includes a bottom plate, a front plate and a rear plate disposed on two opposite sides of the bottom plate. The front plate is provided with a display screen, the rear plate is provided with a socket. The upper cover abuts against the front plate, the rear plate and the bottom plate, and abutting positions are sealed. That is, the upper cover, the front plate, the rear plate and the bottom plate jointly form the waterproof base, and the upper cover may extend with a compensation plate to abut against the front plate, the rear plate or the bottom plate to form a closed cavity.

The first cover body and the second cover body can be disposed in sequence in a direction from the front plate to the rear plate, in such way, along a direction perpendicular to the length direction of the front plate and the rear plate, by moving the first cover body and the second cover body away from each other, the upper cover can be removed from the bottom frame, thus facilitating maintenance on components in the sealed cavity. Alternatively, the first cover body and the second cover body are disposed in sequence in a direction perpendicular to a direction from the front plate to the rear plate. In this way, along a length direction of the front plate and the rear plate, by moving the first cover body and the second cover body away from each other, the upper cover can be removed from the bottom frame to facilitate maintenance on components in the sealed cavity.

Further, the bottom frame further includes a left plate and a right plate disposed on two other opposite sides of the bottom plate, the upper cover abuts against the front plate, the rear plate, the left plate and the right plate, and abutting positions are sealed. That is, the upper cover, the front plate, the rear plate, the left plate, the right plate and the bottom plate jointly form the waterproof base. The upper cover may extend with a compensation plate to abut against the front plate, the rear plate, the left plate, the right plate or the bottom plate to form a closed cavity.

The present invention further provides a stage light fixture, which applies the waterproof base described above.

The light fixture further includes a support arm pivotally connected to the waterproof base and a light head pivotally connected to the support arm. The light head can rotate in a first dimension relative to the support arm, and the support arm can rotate in a second dimension relative to the waterproof base.

### BRIEF DESCRIPTION OF THE DRAWINGS

FIG. 1 is a schematic structural diagram according to one embodiment of the present invention;
FIG. 2 is a schematic structural diagram according to one embodiment of the present invention;
FIG. 3 is a schematic cross-sectional diagram of FIG.2;
FIG. 4 is a schematic structural diagram according to one embodiment of the present invention; and
FIG. 5 is an overall schematic structural diagram of a stage light fixture according to the present invention.

Reference signs: 100 bottom frame, 110 front plate, 120 rear plate, 121 socket, 130 left plate, 140 right plate, 150 decorative plate, 160 bottom plate, 170 handle, 200 upper cover, 210 pivoting hole, 220 first cover body, 230 second cover body, 240 compensation plate, 250 second sealing strip, 260 clamping fastener, 300 oil seal, 310 mounting plate, 320 connecting plate, 330 waterproof rubber strip, 340 accommodating groove, 350 third sealing strip, 360 fixing plate, 400 base, 500 support arm, 600 light head.

### DETAILED DESCRIPTION

The accompanying drawings are for exemplary illustration only, and should not be construed as limitations on this patent; in order to better illustrate this embodiment, some parts in the accompanying drawings may be omitted, enlarged or reduced, and they do not represent the size of the actual product; for those skilled in the art, it is understandable that certain well-known structures and descriptions thereof in the drawings may be omitted. The positional relationship described in the drawings is only for exemplary illustration, and should not be construed as limitations on this patent.

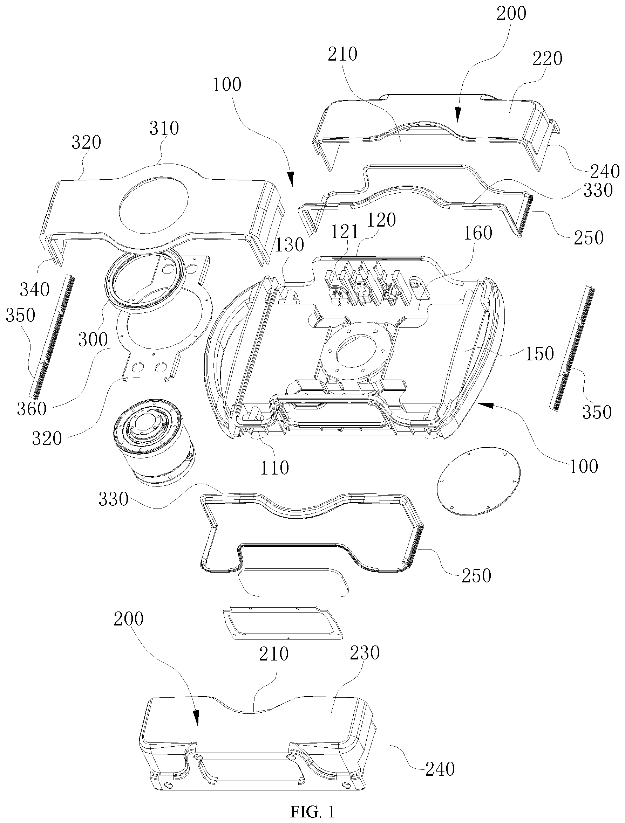

A waterproof base convenient to maintain is provided according to at least one embodiment. Referring to FIG. 1, the waterproof base includes a bottom frame 100 and an upper cover 200 with a pivoting hole 210 covering the bottom frame 100. The bottom frame 100 is integrally formed by die-casting. The upper cover 200 includes a first cover body 220 and a second cover body 230 which are spliced to each other. The pivoting hole 210 is formed by jointly splicing the first cover body 220 and the second cover body 230. An oil seal 300 is provided at the pivoting hole 210, which is configured for sealing the outer side of a pivoting shaft of the light fixture penetrated the pivoting hole 210. The oil seal 300 is fixed by a mounting plate 310. A first sealing strip is further provided to seal the first cover body 220, the second cover body 230 and the mounting plate 310 with respect to each other. The first cover body 220 and the second cover body 230 abut against the bottom frame 100, respectively, and a second sealing strip 250 is provided at each abutting position thereof.

The waterproof base 400 with such configuration that the upper cover 200 is divided into two parts including the first cover body 220 and the second cover body 230, and the pivoting hole 210 is formed by jointly splicing the first cover body 220 and the second cover body 230, so that the upper cover 200 can be easily removed from the bottom frame 100 without disassembling other components to conduct convenient and quick maintenance on the interior of the waterproof base 400. In addition, the oil seal 300 is provided to seal the outer side of a pivoting shaft of the light fixture, the first cover body 220, the second cover body 230 and the mounting plate 300 are sealed with respect to each other by the first sealing strip, and the first cover body 220 and the second cover body 230 respectively abut against the bottom frame 100 with the second sealing strip 250 sealing each abutting position. In such easy way, the whole waterproof base 400 can be waterproof, and the structure of the waterproof base 400 in such configuration can be more flexible than the existing waterproof base in form of a cylinder body by drawing aluminum processing with two end openings closed. The waterproof base according to the embodiment thus can achieve more possibility of modeling designs of the base. Moreover, the bottom frame 100 is integrally formed by die-casting, resulting in rapid processing and high strength, and splicing assembly is not required, accordingly, the waterproof performance is much better.

The bottom frame 100 can be preferably made of a metal material such as aluminum. The upper cover 200 can be made of a metal material or a plastic material, and is preferably made of a metal material.

According to a preferable embodiment of the present invention, the first sealing strip includes two waterproof rubber strips 330. Each waterproof rubber strip 330 is respectively disposed on sides of the first cover body 220 and the second cover body 230 close to each other, which is configured to seal the periphery of the mounting plate 310 close to the first cover body 220 and the second cover body 230, respectively. That is, the waterproof rubber strip 330 may seal a portion where the first cover body 220 or the second cover body 230 and the mounting plate 300 are in contact with each other, and/or seal a portion where the first cover body 220 and the second cover body 230 are in contact with each other, thereby making the entire upper cover 200 waterproof.

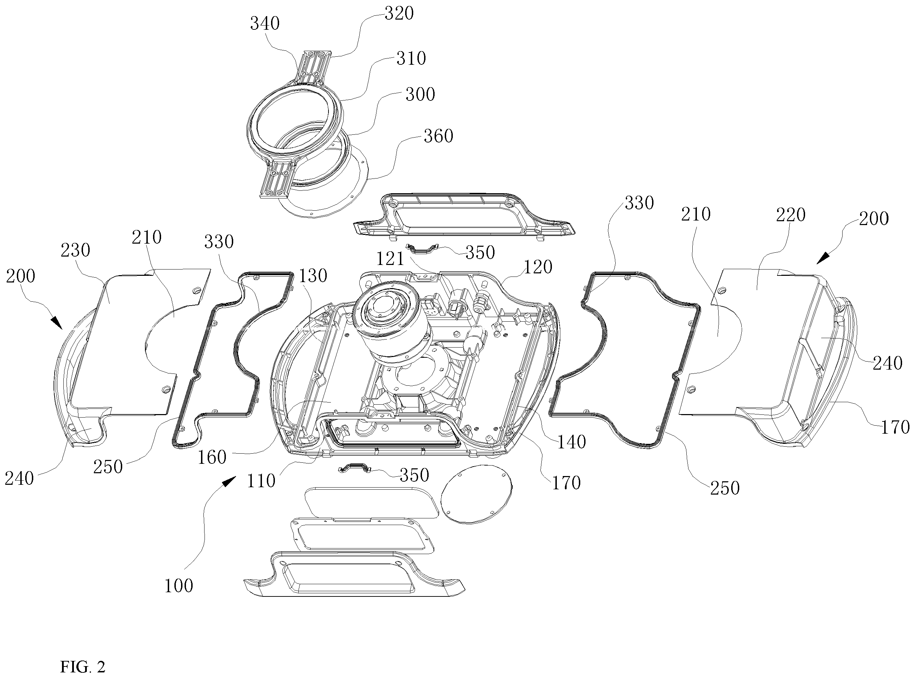

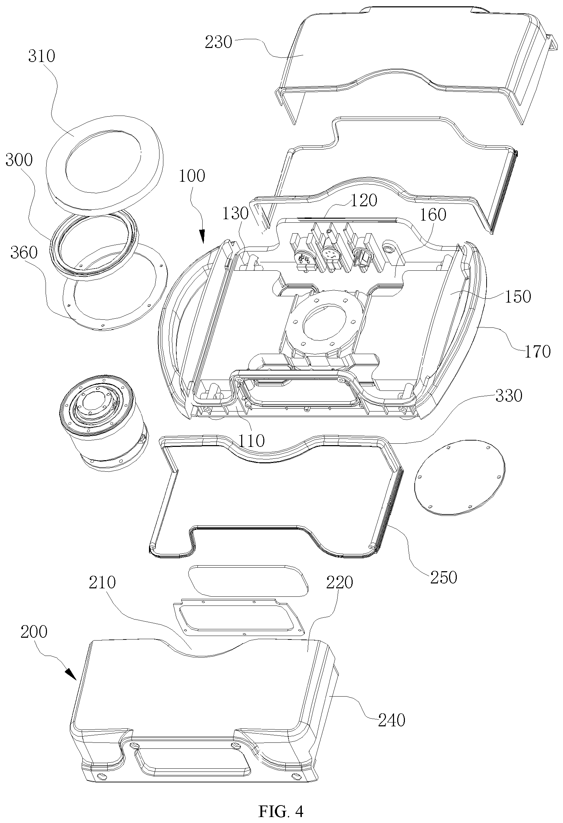

Optionally, according to one embodiment, referring to FIG.1 and FIG. 2, the mounting plate 310 completely separates the first cover body 220 with the second cover body 230. In this case, the first cover body 220 and the second cover body 230 are not in direct contact with each other, each waterproof rubber strip 330 thus seals the portion where the mounting plate 310 is in contact with each cover body 220, 230. According to another embodiment, referring to FIG. 4, the mounting plate 310 does not completely separate the first cover body 220 with the second cover body 230. In this case, the first cover body 220 and the second cover body 230 are at least partially in direct contact with each other, the waterproof rubber strip 330 thus not only seals a portion where the mounting plate 310 is in contact with each cover body 220, 230, but seals a portion where the first cover body 220 and the second cover body 230 are in direct contact with each other, thereby making the entire upper cover 200 waterproof.

In a preferable embodiment of the present invention, the second sealing strips 250 disposed between the first cover body 220 and the bottom frame 100 as well as between the second cover body 230 and the bottom frame 100 are independent from each other, and each second sealing strip is respectively connected with each waterproof rubber strip 330 into a whole. That is, each second sealing strip 250 and each waterproof rubber strip 330 are connected into a rubber ring to seal the periphery of the first cover body 220 or the second cover body 230, so that there is no splicing gap between the second sealing strip 250 and the waterproof rubber strip 330, thus achieving better waterproof performance.

Preferably, two of the rubber rings are in close abutting connection to achieve waterproofness, or two of the rubber rings are in abutting connection with a third sealing strip 350 to achieve waterproofness.

According to a preferable embodiment of the present invention, referring to FIG. 2, the first sealing strip is located on a side of the mounting plate 310 away from the bottom frame 100. In such configuration, the first cover body 220 and the second cover body 230 may be horizontally pushed or pressed from top to bottom to assembly together. In the embodiment shown in FIG.2, the first cover body 230 and the second cover body 230 are preferably pressed from top to bottom.

Accordingly, an accommodating groove 340 for accommodating each first sealing strip is respectively formed in a side of the mounting plate 310 away from the bottom frame 100. In this way, the first sealing strip is fixed to the mounting plate 310, so that when the first cover body 220 and the second cover body 230 are disassembled and assembled, the first sealing strip is not necessary to be removed.

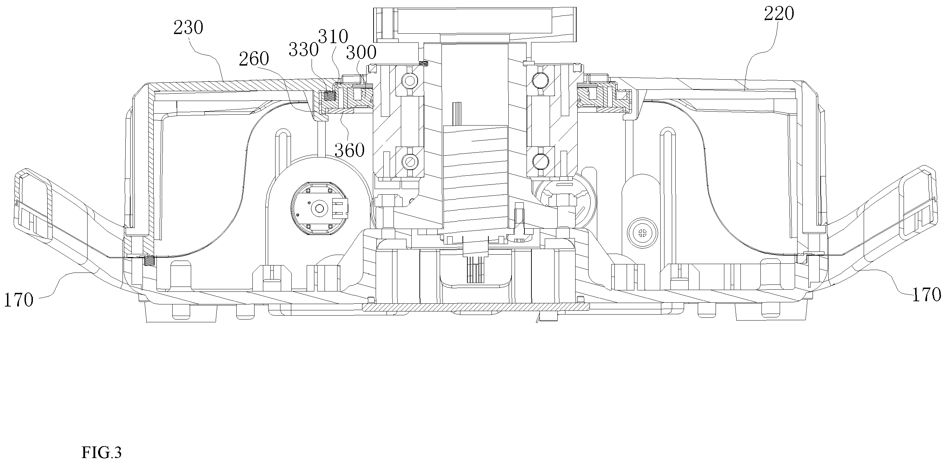

According to a preferable embodiment of the present invention, as shown in FIG.3, a clamping fastener 260 is provided on the first cover body 220 and/or the second cover body 230, which is supported on a side of the mounting plate 310 close to the bottom frame 100. The clamping fastener 260 enables the first cover body 220 and/or the second cover body 230 to be fastened to the mounting plate 310, so as to ensure that the first sealing strip is always in a compressed state, thereby achieving more stable waterproof performance.

Optionally, a plurality of clamping fasteners 260 may be provided, or the clamp fastener 260 may be formed into a continuous one along the circumference of the first cover body 220 and/or the second cover body 230.

Referring back to FIG. 1, in a preferable embodiment of the present invention, the first sealing strip is located on a side of the mounting plate 310 close to the first cover body 220 and the second cover body 230. In this way, the first cover body and the second cover body may be horizontally pushed to assembly the first cover body 220 and the second cover body 230.

Accordingly, an accommodating groove 340 for accommodating the first sealing strip is formed on a side of the mounting plate 310 close to the first cover body 220 and the second cover body 230, and an edge of the first cover body 220 and/or the second cover body 230 is at least partially inserted into the accommodating groove 340. In this way, the first sealing strip is fixed to the mounting plate 310, and the edge of the first cover body 220 and/or the second cover body 230 is at least partially inserted into the accommodating groove 340 and cooperates with the side wall of the accommodating groove 340 to press against the first sealing strip, so that more stable waterproof performance can be realized.

In a preferable embodiment of the present invention, the first sealing strip at least partially extends out of the accommodating groove 340 and is bent to tighten the outer side wall of the accommodating groove 340. In such a way, the first sealing strip can be fixed more firmly, and the first sealing strip can prevent from being displaced or twisted when the edge of the first cover body 220 and/or the second cover body 230 is inserted into the accommodating groove 340.

In a preferable embodiment of the present invention, the second sealing strip 250 is located on a side of the bottom frame 100 close to the mounting plate 310, or is located on the outer side of the bottom frame 100, or is partially located on the side of the bottom frame 100 close to the mounting plate 310, and partially located on the outer side of the bottom frame 100.

As in FIG. 1 and FIG. 2, in a preferable embodiment of the present invention, each side of the mounting plate 310 extends along the cover body 220, 320 to form a connecting plate. Each connecting plate 320 is fixed to the bottom frame 100, the sides of the first cover body 220 and the second cover body 230 close to each other respectively abut against the mounting plate 310, and the first sealing strip is disposed between the first cover body 220 and the mounting plate 310 as well as between the second cover body 230 and the mounting plate 310 respectively. In this way, the first cover body 220 and the second cover body 230 are not in direct contact with each other. The connecting plate 320 is located between the first cover body 220 and the second cover body 230, the first cover body 220 and the second cover body 230 respectively abut against and are sealed to the mounting plate 310, and the end of the mounting plate 310 is fixed to the bottom frame 100. The configuration of the mounting plate 310 can improve the strength of the upper cover 200, especially when the upper cover 200 is made of a plastic material.

In a preferable embodiment of the present invention, a third sealing strip 350 is disposed at a position where the bottom frame 100 abuts against the connecting plate 320, and the third sealing strip 350 abuts against the first sealing strip or the second sealing strip 250 into a whole, or connects with the first sealing strip or the second sealing strip 250 into a whole. In such a way, the third sealing strip 350 not only seals the mounting plate 310 and the bottom frame 100, and the third sealing strip 350 is also in sealed connection with the first sealing strip or the second sealing strip 250, thereby realizing the waterproof performance of the waterproof base 400.

As in FIG. 1, according to a preferable embodiment of the present invention, a fixing plate 360 for fixing the oil seal 300 to the mounting plate 310 is further provided. The fixing plate 360 includes two connecting plates 320 respectively extending from two opposite sides perpendicular to the cover body 220, 230, which are fixed to the bottom frame 100. The fixing plate 360 can support the upper cover 200 to improve the strength of the waterproof base 400, especially when the waterproof base 400 is made of a plastic material.

As in FIG. 4, in a preferable embodiment of the present invention, the mounting plate 310 is fixed to a bottom plate 160 of the bottom frame 100 via a connecting column.

In a preferable embodiment of the present invention, except the bottom plate 160, the bottom frame 100 includes a front plate 110 and a rear plate 120 disposed on two opposite sides of the bottom plate 160. The front plate 110 is provided with a display screen, the rear plate 120 is provided with a socket 121. The upper cover 200 abuts against the front plate 110, the rear plate 120 and the bottom plate 160, and abutting positions are sealed. That is, the upper cover 200, the front plate 110, the rear plate 120 and the bottom plate 160 jointly form the waterproof base 400. The upper cover 200 may extend with a compensation plate 240 to abut against the front plate 110, the rear plate 120 or the bottom plate 160 to form a closed cavity.

Optionally, the second sealing strip 250 is used to seal portions of the front plate 110 and the rear plate 120 abutting against the upper cover 200, which are located on sides of the front plate 110 and the rear plate 120 away from each other.

As in FIG. 2, optionally, the connecting plates 320 extending from two opposite sides of the mounting plate 310 along the cover body 220, 230 is each fixed to the front plate 110 and the rear plate 120.

According to one embodiment, referring to FIG. 1 and FIG. 4, the first cover body 220 and the second cover body 230 are disposed in sequence in a direction from the front plate 110 to the rear plate 120. In such way, along a direction perpendicular to the length direction of the front plate 110 and the rear plate 120, by moving the first cover body 220 and the second cover body 230 away from each other, the upper cover 200 can be removed from the bottom frame 100, thus facilitating maintenance on components in the sealed cavity. According to another embodiment, referring to FIG. 2, the first cover body 220 and the second cover body 230 are disposed in sequence in a direction perpendicular to a direction from the front plate 110 to the rear plate 120. In this way, along the length direction of the front plate 110 and the rear plate 120, by moving the first cover body 220 and the second cover body 230 away from each other, the upper cover 200 can be removed from the bottom frame 100 to facilitate maintenance on components in the sealed cavity.

In other embodiments, the first cover body 220 and the second cover body 230 can be set in any direction as long as they can form a closed cavity with the bottom frame 100, for example, the projection of the first cover body 220 and the second cover body 230 on the bottom frame 100 is L-shaped.

As in FIG. 1 and FIG. 2, according to a preferable embodiment of the present invention, the bottom frame 100 further includes a left plate 130 and a right plate 140 disposed on two other opposite sides of the bottom plate 160, the upper cover 200 abuts against the front plate 110, the rear plate 120, the left plate 130 and the right plate 140, and abutting positions are sealed. That is, the upper cover 200, the front plate 110, the rear plate 120, the left plate 130, the right plate 140 and the bottom plate 160 jointly form the waterproof base 400. The upper cover 200 may extend with a compensation plate 240 to abut against the front plate 110, the rear plate 120, the left plate 130, the right plate 140 or the bottom plate 160 to form a closed cavity.

Preferably, a decorative plate 150 extends outside the left plate 130 and the right plate 140. The decorative plate 150 can be freely designed in shape and cooperates with the upper cover 200 to be shaped. In this situation, the upper cover 200 is still sealed to the left plate 130 and the right plate 140 directly.

Optionally, the second sealing strip 250 is used to seal portions of the left plate 130 and the right plate 140 abutting against the upper cover 200, which are located on sides of the left plate 130 and the right plate 140 close to the mounting plate 310.

As in FIG. 1, optionally, the connecting plate 320 extending from both sides of the mounting plate 310 is fixed to the left plate 130 and the right plate 140, respectively.

As in FIG. 1, optionally, the connecting plate 320 extending from both sides of the fixing plate 360 is fixed to the front plate 110 and the rear plate 120, respectively.

Optionally, the left plate 130 and the right plate 140 may have a low height, protruding out of the bottom plate 160 within 3 CM.

In the embodiment shown in FIG.1, the second sealing strip 250 is disposed along the periphery of the bottom plate 160, and the top end of the left plate 130, the right plate 140, the front plate 110 and the rear plate 120.

Preferably, a handle 170 is provided outside the left plate 130 and the right plate 140.

Optionally, the handle 170 is integrally formed with the left plate 130 and the right plate 140.

As in FIG. 2, preferably, another handle 170 is provided outside the first cover body 220 and the second cover body 230.

Optionally, the handle 170 on the first cover body 220 and the second cover body 230is integrally formed with the first cover body 220 and the second cover body 230.

Optionally, the handle 170 provided outside the left plate 130 and the right plate 140, and the handle 170 provided outside the first cover body 220 and the second cover body 230 are buckled into a whole.

As shown in FIG. 1, preferably, the connecting position of the connecting plate 320 with the front plate 110 and the rear plate 120 is located within the sealing range of the upper cover 200 with the front plate 110 and the rear plate 120.

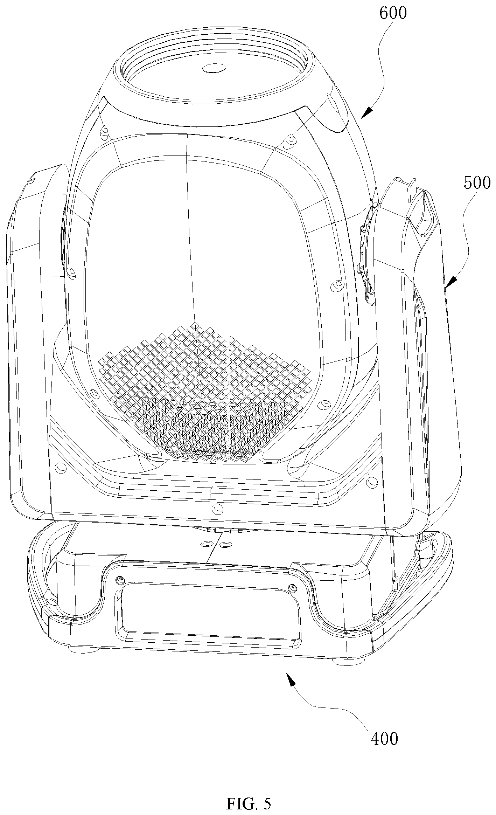

As shown in FIG. 5, a stage light fixture is further provided, which includes the waterproof base 400 described above.

The light fixture further includes a support arm 500 pivotally connected to the waterproof base 400 and a light head 600 pivotally connected to the support arm 500. The light head 600 can rotate in a first dimension relative to the support arm 500, and the support arm 500 can rotate in a second dimension relative to the waterproof base 400.

Obviously, the above-mentioned embodiments of the present invention are only examples for clearly illustrating the present invention, rather than limiting the implementation modes of the present invention. For those of ordinary skill in the art, changes or modifications in other different forms can also be made on the basis of the above description. It is not needed and it is impossible to list all implementation modes here.

## Claims

1. A waterproof base (400) convenient to maintain, comprising
a bottom frame (100), which is integrally formed by die-casting; and
an upper cover (200) with a pivoting hole (210) covering on the bottom frame (100), which has a first cover body (220) and a second cover body (230) spliced to each other, the pivoting hole (210) being formed by jointly splicing the first cover body (220) and the second cover body (230),
wherein an oil seal for sealing an outer side of a pivoting shaft penetrating the pivoting hole (210) is disposed at the pivoting hole (210), which is mounted and fixed by a mounting plate (310),
a first sealing strip is configured for sealing the first cover body (220), the second cover body (230) and the mounting plate (310) with respect to each other, and
the first cover body (220) and the second cover body (230) are respectively abutted against the bottom frame (100) with a second sealing strip (250) disposed at each abutting position.

2. The waterproof base (400) convenient to maintain according to claim 1, wherein the first sealing strip comprises two waterproof rubber strips (330), each being respectively disposed on sides of the first cover body (220) and the second cover body (230) close to each other, which respectively seal the periphery of the mounting plate (310) close to the first cover body (220) and the second cover body (230).

3. The waterproof base (400) convenient to maintain according to claim 2, wherein the second sealing strip (250) disposed between the first cover body (220) and the bottom frame (100) is independent from the second sealing strip (250) disposed between the second cover body (230) and the bottom frame (100), and each second sealing strip (250) is respectively connected with each waterproof rubber strip (330) into a whole.

4. The waterproof base (400) convenient to maintain according to claim 1, wherein the first sealing strip is located on a side of the mounting plate (310) away from the bottom frame (100).

5. The waterproof base convenient to maintain according to claim 1, wherein the first sealing strip is located on a side of the mounting plate (310) away from the pivoting hole (210).

6. The waterproof base convenient to maintain according to claim 5, wherein an accommodating groove (340) for accommodating the first sealing strip is formed on a side of the mounting plate (310) away from the pivoting hole (210), and an edge of the first cover body (220) and/or the second cover body (230) is at least partially inserted into the accommodating groove (340).

7. The waterproof base (400) convenient to maintain according to claim 1, wherein the second sealing strip (250) is located on a side of the bottom frame (100) close to the mounting plate (310), or is located on the outer side of the bottom frame (100), or is partially located on the side of the bottom frame (100) close to the mounting plate (310), and partially located on the outer side of the bottom frame (100).

8. The waterproof base (400) convenient to maintain according to claim 1, wherein each of two opposite sides of the mounting plate (310) forms a connecting plate (320), each connecting plate (320) is fixed to the bottom frame (100), the sides of the first cover body (220) and the second cover body (230) close to each other respectively abut against the mounting plate (310), and the first sealing strip is disposed between the first cover body (220) and the mounting plate (310) as well as between the second cover body (230) and the mounting plate (310) respectively.

9. The waterproof base (400) convenient to maintain according to claim 8, wherein a third sealing strip (350) is disposed at a position where the bottom frame (100) abuts against the connecting plate (320), and the third sealing strip (350) abuts against the first sealing strip or the second sealing strip (250) into a whole, or connects with the first sealing strip or the second sealing strip (250) into a whole.

10. The waterproof base (400) convenient to maintain according to claim 1, further comprising a fixing plate (360) for fixing the oil seal (300) to the mounting plate (310), which has two connecting plates (320), each connecting plate (320) being extending from two opposite sides of the fixing plate (360) respectively, and being fixed to the bottom frame (100).

11. The waterproof base (400) convenient to maintain according to claim 1, wherein the mounting plate (310) is fixed to a bottom plate (160) of the bottom frame (100) via a connecting column.

12. The waterproof base (400) convenient to maintain according to claim 1, wherein the bottom frame (100) comprises a bottom plate (160), and a front plate (110) and a rear plate (120) disposed on two opposite sides of the bottom plate (160), the front plate (110) is provided with a display screen, the rear plate (120) is provided with a socket (121), the upper cover (200) abuts against the front plate (110), the rear plate (120) and the bottom plate (160), and abutting positions are sealed by the first sealing strip and the second sealing strip (250).

13. The waterproof base (400) convenient to maintain according to claim 12, wherein the first cover body (220) and the second cover body (230) are disposed in sequence in a direction from the front plate (110) to the rear plate (120), or the first cover body (2200) and the second cover body (230) are disposed in sequence in a direction perpendicular to a direction from the front plate (110) to the rear plate (120).

14. The waterproof base (400) convenient to maintain according to claim 12, wherein the bottom frame (100) further comprises a left plate (130) and a right plate (140) disposed on two other opposite sides of the bottom plate (160), the upper cover (200) abuts against the front plate (110), the rear plate (120), the left plate (130) and the right plate (140), and abutting positions are sealed by the first sealing strip and the second sealing strip (250).

15. A stage light fixture, comprising the waterproof base (400) according to any one of claims 1-14, a support arm (500) pivotally connected to the waterproof base (400), and a light head (600) pivotally connected to the support arm (500), wherein the light head (600) is configured to rotate in a first dimension relative to the support arm (500), and the support arm (500) is configured to rotate in a second dimension relative to the waterproof base (400).

## Patentansprüche

1. Wasserdichte Basis (400), die wartungszugänglich ist, umfassend
einen Bodenrahmen (100), der integral durch Druckguss geformt ist; und
eine Oberabdeckung (200) mit einem Schwenkloch (210), die den Bodenrahmen (100) abdeckt, welche einen ersten Abdeckkörper (220) und einen zweiten Abdeckkörper (230) aufweist, die aneinandergefügt sind, **dadurch gekennzeichnet, dass** das Schwenkloch (210) durch gemeinsames Fügen des ersten Abdeckkörpers (220) und des zweiten Abdeckkörpers (230) gebildet wird,
wobei am Schwenkloch (210) eine Wellendichtung zur Abdichtung der Außenseite einer durch das Schwenkloch (210) hindurchgeführten Schwenkwelle angeordnet ist, welche mittels einer Montageplatte (310) montiert und befestigt ist,
ein erster Dichtungsstreifen zur wechselseitigen Abdichtung des ersten Abdeckkörpers (220), des zweiten Abdeckkörpers (230) und der Montageplatte (310) konfiguriert ist, und
der erste Abdeckkörper (220) und der zweite Abdeckkörper (230) jeweils gegen den Bodenrahmen (100) anliegen und an jeder Anliegeposition ein zweiter Dichtungsstreifen (250) angeordnet ist.

2. Wasserdichte Basis (400), die wartungszugänglich ist, nach Anspruch 1, wobei der erste Dichtungsstreifen zwei wasserdichte Gummidichtungsstreifen (330) umfasst, von denen jeweils einer an den einander zugewandten Seiten des ersten Abdeckkörpers (220) und des zweiten Abdeckkörpers (230) angeordnet ist, welche den Umfangsbereich der Montageplatte (310) in den dem ersten Abdeckkörper (220) bzw. dem zweiten Abdeckkörper (230) benachbarten Bereichen abdichten.

3. Wasserdichte Basis (400), die wartungszugänglich ist, nach Anspruch 2, wobei der zwischen dem ersten Abdeckkörper (220) und dem Bodenrahmen (100) angeordnete zweite Dichtungsstreifen (250) unabhängig von dem zwischen dem zweiten Abdeckkörper (230) und dem Bodenrahmen (100) angeordneten zweiten Dichtungsstreifen (250) ist, und jeder zweite Dichtungsstreifen (250) jeweils mit dem zugeordneten wasserdichten Gummidichtungsstreifen (330) zu einer Einheit verbunden ist.

4. Wasserdichte Basis (400), die wartungszugänglich ist, nach Anspruch 1, wobei der erste Dichtungsstreifen auf der dem Bodenrahmen (100) abgewandten Seite der Montageplatte (310) angeordnet ist.

5. Wasserdichte Basis (400), die wartungszugänglich ist, nach Anspruch 1, wobei der erste Dichtungsstreifen auf der dem Schwenkloch (210) abgewandten Seite der Montageplatte (310) angeordnet ist.

6. Wasserdichte Basis (400), die wartungszugänglich ist, nach Anspruch 5, wobei eine Aufnahmenut (340) zur Aufnahme des ersten Dichtungsstreifens auf der dem Schwenkloch (210) abgewandten Seite der Montageplatte (310) gebildet ist, wobei eine Kante des ersten Abdeckkörpers (220) und/oder des zweiten Abdeckkörpers (230) zumindest teilweise in die Aufnahmenut (340) hineinragt.

7. Wasserdichte Basis (400), die wartungszugänglich ist, nach Anspruch 1, wobei der zweite Dichtungsstreifen (250) an der zur Montageplatte (310) hin gewandten Seite des Bodenrahmens (100) angeordnet ist, oder an der Außenseite des Bodenrahmens (100) angeordnet ist, oder teilweise an der zur Montageplatte (310) hin gewandten Seite des Bodenrahmens (100) und teilweise an der Außenseite des Bodenrahmens (100) angeordnet ist.

8. Wasserdichte Basis (400), die wartungszugänglich ist, nach Anspruch 1, wobei an zwei gegenüberliegenden Seiten der Montageplatte (310) jeweils eine Verbindungsplatte (320) ausgebildet ist, die am Bodenrahmen (100) befestigt sind, wobei die einander zugewandten Seiten des ersten Abdeckkörpers (220) und des zweiten Abdeckkörpers (230) gegen die Montageplatte (310) anliegen, und wobei der erste Dichtungsstreifen sowohl zwischen dem ersten Abdeckkörper (220) und der Montageplatte (310) als auch zwischen dem zweiten Abdeckkörper (230) und der Montageplatte (310) angeordnet ist.

9. Wasserdichte Basis (400), die wartungszugänglich ist, nach Anspruch 8, wobei ein dritter Dichtungsstreifen (350) an der Anlageposition zwischen dem Bodenrahmen (100) und der Verbindungsplatte (320) angeordnet ist, und wobei der dritte Dichtungsstreifen (350) mit dem ersten Dichtungsstreifen oder dem zweiten Dichtungsstreifen (250) einstückig ausgebildet ist oder mit diesem verbunden ist.

10. Wasserdichte Basis (400), die wartungszugänglich ist, nach Anspruch 1, ferner umfassend eine Befestigungsplatte (360) zur Befestigung der Wellendichtung (300) an der Montageplatte (310), wobei die Befestigungsplatte (360) zwei Verbindungsplatten (320) aufweist, wobei sich jede Verbindungsplatte (320) von gegenüberliegenden Seiten der Befestigungsplatte (360) erstreckt und am Bodenrahmen (100) befestigt ist.

11. Wasserdichte Basis (400), die wartungszugänglich ist, nach Anspruch 1, wobei die Montageplatte (310) über eine Verbindungssäule an einer Bodenplatte (160) des Bodenrahmens (100) befestigt ist.

12. Wasserdichte Basis (400), die wartungszugänglich ist, nach Anspruch 1, wobei der Bodenrahmen (100) eine Bodenplatte (160) sowie eine an gegenüberliegenden Seiten der Bodenplatte (160) angeordnete Frontplatte (110) und Rückplatte (120) umfasst, wobei die Frontplatte (110) einen Anzeigebildschirm aufweist, wobei die Rückplatte (120) eine Anschlussbuchse (121) aufweist, wobei die Oberabdeckung (200) an die Frontplatte (110), die Rückplatte (120) und die Bodenplatte (160) dichtend angrenzt, und wobei die Angrenzungspositionen durch den ersten Dichtungsstreifen und den zweiten Dichtungsstreifen (250) abgedichtet sind.

13. Wasserdichte Basis (400), die wartungszugänglich ist, nach Anspruch 12, wobei der erste Abdeckkörper (220) und der zweite Abdeckkörper (230) aufeinanderfolgend in Richtung von der Frontplatte (110) zur Rückplatte (120) angeordnet sind, oder aufeinanderfolgend in einer Richtung senkrecht zur Richtung von der Frontplatte (110) zur Rückplatte (120) angeordnet sind.

14. Wasserdichte Basis (400), die wartungszugänglich ist, nach Anspruch 12, wobei der Bodenrahmen (100) ferner eine linke Seitenplatte (130) und eine rechte Seitenplatte (140) umfasst, die an zwei anderen gegenüberliegenden Seiten der Bodenplatte (160) angeordnet sind, wobei die Oberabdeckung (200) gegen die Frontplatte (110), die Rückplatte (120), die linke Seitenplatte (130) und die rechte Seitenplatte (140) anliegt, und wobei die Anliegepositionen durch den ersten Dichtungsstreifen und den zweiten Dichtungsstreifen (250) abgedichtet sind.

15. Bühnenleuchte, umfassend eine wasserdichte Basis (400) nach einem der Ansprüche 1-14, einen Tragarm (500) und einen Leuchtkopf (600), **dadurch gekennzeichnet, dass** der Tragarm (500) schwenkbar mit der wasserdichten Basis (400) verbunden ist, der Leuchtkopf (600) schwenkbar mit dem Tragarm (500) verbunden ist, der Leuchtkopf (600) in einer ersten Dimension relativ zum Tragarm (500) drehbar ist, und der Tragarm (500) in einer zweiten Dimension relativ zur wasserdichten Basis (400) drehbar ist.

## Revendications

1. Une base étanche (400) facile à entretenir, comprenant :
un cadre inférieur (100), formé de manière monobloc par moulage sous pression ; et
un couvercle supérieur (200) pourvu d'un trou de pivotement (210) et recouvrant le cadre inférieur (100), le couvercle supérieur comprenant un premier corps de couvercle (220) et un deuxième corps de couvercle (230) assemblés l'un à l'autre, le trou de pivotement (210) étant formé par l'assemblage conjoint du premier corps de couvercle (220) et du deuxième corps de couvercle (230),
dans laquelle un joint à huile destiné à étanchéifier un côté extérieur d'un arbre de pivotement traversant le trou de pivotement (210) est disposé au niveau du trou de pivotement (210), le joint à huile étant monté et fixé au moyen d'une plaque de montage (310),
une première bande d'étanchéité est conçue pour étanchéifier le premier corps de couvercle (220), le deuxième corps de couvercle (230) et la plaque de montage (310) les uns par rapport aux autres, et
le premier corps de couvercle (220) et le deuxième corps de couvercle (230) viennent chacun en butée contre le cadre inférieur (100), une deuxième bande d'étanchéité (250) étant disposée à chaque position de butée.

2. La base étanche (400) facile à entretenir selon la revendication 1, dans laquelle la première bande d'étanchéité comprend deux bandes en caoutchouc étanche (330) disposées respectivement sur les côtés du premier corps de couvercle (220) et du deuxième corps de couvercle (230) proches l'un de l'autre, et étanchéifiant respectivement la périphérie de la plaque de montage (310) proche du premier corps de couvercle (220) et du deuxième corps de couvercle (230).

3. La base étanche (400) facile à entretenir selon la revendication 2, dans laquelle la deuxième bande d'étanchéité (250) disposée entre le premier corps de couvercle (220) et le cadre inférieur (100) est indépendante de la deuxième bande d'étanchéité (250) disposée entre le deuxième corps de couvercle (230) et le cadre inférieur (100), et chaque deuxième bande d'étanchéité (250) est respectivement reliée à chaque bande en caoutchouc étanche (330) pour former un ensemble.

4. La base étanche (400) facile à entretenir selon la revendication 1, dans laquelle la première bande d'étanchéité est située sur le côté de la plaque de montage (310) opposé au cadre inférieur (100).

5. La base étanche (400) facile à entretenir selon la revendication 1, dans laquelle la première bande d'étanchéité est située sur le côté de la plaque de montage (310) opposé au trou de pivotement (210).

6. La base étanche (400) facile à entretenir selon la revendication 5, **caractérisée en ce qu'**une rainure de réception (340) destinée à recevoir la première bande d'étanchéité est formée sur le côté de la plaque de montage (310) opposé au trou de pivotement (210), et un bord du premier corps de couvercle (220) et/ou du deuxième corps de couvercle (230) est inséré au moins partiellement dans la rainure de réception (340).

7. La base étanche (400) facile à entretenir selon la revendication 1, dans laquelle la deuxième bande d'étanchéité (250) est située sur le côté du cadre inférieur (100) proche de la plaque de montage (310), ou est située sur le côté extérieur du cadre inférieur (100), ou partiellement sur le côté du cadre inférieur (100) proche de la plaque de montage (310) et partiellement sur le côté extérieur du cadre inférieur (100).

8. La base étanche (400) facile à entretenir selon la revendication 1, dans laquelle chacun des deux côtés opposés de la plaque de montage (310) forme une plaque de connexion (320), chaque plaque de connexion (320) étant fixée au cadre inférieur (100), les côtés du premier corps de couvercle (220) et du deuxième corps de couvercle (230) proches l'un de l'autre viennent respectivement en butée contre la plaque de montage (310), et la première bande d'étanchéité est disposée entre le premier corps de couvercle (220) et la plaque de montage (310), ainsi qu'entre le deuxième corps de couvercle (230) et la plaque de montage (310).

9. La base étanche (400) facile à entretenir selon la revendication 8, dans laquelle une troisième bande d'étanchéité (350) est disposée à une position où le cadre inférieur (100) vient en butée contre la plaque de connexion (320), et la troisième bande d'étanchéité (350) est en butée contre la première bande d'étanchéité ou la deuxième bande d'étanchéité (250) pour former un ensemble, ou reliée à la première bande d'étanchéité ou la deuxième bande d'étanchéité (250) pour former un ensemble.

10. La base étanche (400) facile à entretenir selon la revendication 1, comprenant en outre une plaque de fixation (360) destinée à fixer le joint à huile (300) à la plaque de montage (310), la plaque de fixation comprenant deux plaques de connexion (320), chaque plaque de connexion (320) s'étendant respectivement depuis les deux côtés opposés de la plaque de fixation (360), et étant fixée au cadre inférieur (100).

11. La base étanche (400) facile à entretenir selon la revendication 1, dans laquelle la plaque de montage (310) est fixée à une plaque inférieure (160) du cadre inférieur (100) par l'intermédiaire d'une colonne de connexion.

12. La base étanche (400) facile à entretenir selon la revendication 1, dans laquelle le cadre inférieur (100) comprend une plaque inférieure (160), ainsi qu'une plaque avant (110) et une plaque arrière (120) disposées sur les deux côtés opposés de la plaque inférieure (160), la plaque avant (110) étant pourvue d'un écran d'affichage, la plaque arrière (120) étant pourvue d'une prise (121), le couvercle supérieur (200) venant en butée contre la plaque avant (110), la plaque arrière (120) et la plaque inférieure (160), et les positions de butée étant étanchéifiées par la première bande d'étanchéité et la deuxième bande d'étanchéité (250).

13. La base étanche (400) facile à entretenir selon la revendication 12, dans laquelle le premier corps de couvercle (220) et le deuxième corps de couvercle (230) sont disposés successivement dans la direction allant de la plaque avant (110) à la plaque arrière (120), ou le premier corps de couvercle (220) et le deuxième corps de couvercle (230) sont disposés successivement dans une direction perpendiculaire à la direction allant de la plaque avant (110) à la plaque arrière (120).

14. La base étanche (400) facile à entretenir selon la revendication 12, dans laquelle le cadre inférieur (100) comprend en outre une plaque gauche (130) et une plaque droite (140) disposées sur les deux autres côtés opposés de la plaque inférieure (160), le couvercle supérieur (200) venant en butée contre la plaque avant (110), la plaque arrière (120), la plaque gauche (130) et la plaque droite (140), et les positions de butée étant étanchéifiées par la première bande d'étanchéité et la deuxième bande d'étanchéité (250).

15. Un projecteur de scène, comprenant la base étanche (400) selon l'une quelconque des revendications 1 à 14, un bras de support (500) relié de manière pivotante à la base étanche (400), et une tête de lumière (600) reliée de manière pivotante au bras de support (500), dans lequel la tête de lumière (600) est conçue pour tourner selon une première dimension par rapport au bras de support (500), et le bras de support (500) est conçu pour tourner selon une deuxième dimension par rapport à la base étanche (400).
